# EUROPEAN PATENT APPLICATION

(11) **EP 2 184 587 A1**
(43) Date of publication of application: **12.05.2010**
(21) Application number: 09252469.3
(22) Date of filing: 22.10.2009
(51) Int. Cl.: G01D 18/00, G01R 13/02, G01R 13/32, G01R 19/25, G01R 35/00, H04L 12/24, H04L 12/26

(54) **Method and apparatus for time synchronization of events for multiple instruments**

(30) Priority: 26.06.2009 US 492886; 05.11.2008 US 111406
(71) Applicant: Tektronix, Inc., Beaverton, OR 97077-0001 (US)
(72) Inventor: Wang, Zhongsheng, Oregon 97006 (US); Tran, Que T, Oregon 97007 (US); Schmidt, Nicholas, Oregon 97229 (US)
(74) Representative: Brinck, David John Borchardt

(57) **Abstract**

A measurement system including a plurality of test and measurement instruments; and a hub coupled to each of the test and measurement instruments. Each of the test and measurement instruments is configured to trigger an acquisition in response to a hub event received from the hub. Acquisitions can be triggered from one, some, any, or all of the test and measurement instruments.

## Description

### CROSS-REFERENCE TO RELATED APPLICATIONS

This application claims priority under 35 U.S.C. § 119(e) from U.S. Provisional Application serial number 61/111,406, filed on November 5, 2008, the contents of which are herein incorporated by reference in their entirety.

### BACKGROUND

This disclosure relates to test and measurement instruments, in particular to triggering of multiple test and measurement instruments.

An event on a test and measurement instrument can be used to trigger an acquisition on other test and measurement instruments. For example, a first test and measurement instrument can have a trigger output. The trigger output can output a signal indicating that the first test and measurement instrument has detected conditions that can cause an acquisition.

Other test and measurement instruments can be coupled to the trigger output of the first test and measurement instrument. These test and measurement instruments can trigger an acquisition in response to the external trigger from the first test and measurement instrument. Thus, the acquisition of multiple instruments can be triggered by events detected by one test and measurement instrument.

### SUMMARY

Aspects of the present invention are set out in the accompanying claims. An embodiment includes a measurement system including a plurality of test and measurement instruments; and a hub coupled to each of the test and measurement instruments. Each of the test and measurement instruments is configured to trigger an acquisition in response to a hub event received from the hub.

Another embodiment includes a test and measurement instrument including an input configured to receive an event; and a controller coupled to the input and configured to trigger an acquisition in response to the event and a time associated with the test and measurement instrument and at least one other test and measurement instrument.

Another embodiment includes measuring a round-trip time from a hub to a test and measurement instrument; receiving an event from the hub at the test and measurement instrument; acquiring data in response to the event; and adjusting a time base of a presentation of the data in response to the round-trip time.

A further aspect of the invention provides a test and measurement instrument comprising an input configured to receive an event and a controller coupled to the input and configured to trigger an acquisition of data in response to the event and offset the acquired data in response to an offset time associated with the test and measurement instrument and at least one other test and measurement instrument. The event may be a first event, with the test and measurement instrument further comprising an event decoder configured to output a second event, wherein the controller is configured to measure a round-trip time between the first event and the second event and set the offset time in response to the round-trip time.
The test and measurement instrument may further comprise an adjustable delay configured to delay the second event, and an output configured to output the delayed second event.

### BRIEF DESCRIPTION OF THE DRAWINGS

FIGURE 1 is a block diagram of a measurement system according to an embodiment.

FIGURE 2 is a block diagram illustrating a connection of a test and measurement instrument and a hub in the measurement system of FIGURE 1.

FIGURES 3 and 4 are timing diagrams illustrating measurements of round-trip times for two test and measurement instruments according to an embodiment.

FIGURE 5 is a timing diagram illustrating an event from a first test and measurement instrument propagating to multiple test and measurement instruments according to an embodiment.

FIGURE 6 is a timing diagram illustrating an event from a second test and measurement instrument propagating to multiple test and measurement instruments according to an embodiment.

FIGURE 7 is a diagram illustrating a time relationship of waveforms on a device under test according to an embodiment.

FIGURE 8 is a diagram illustrating a time relationship of the waveforms of FIGURE 7 with the respective trigger points aligned.

FIGURE 9 is a diagram illustrating a time relationship of the waveforms offset in time according to an embodiment.

FIGURE 10 is a block diagram of a hub according to an embodiment.

FIGURE 11 is a flowchart illustrating an example of a calibration of multiple test and measurement instruments.

FIGURE 12 is a block diagram of a test and measurement instrument according to an embodiment.

### DETAILED DESCRIPTION

Embodiments include test and measurement instruments, measurement systems, calibration and measurement techniques, or the like where an event generated on one or more test and measurement instruments can be used to trigger acquisition on any or all of the test and measurement instruments.

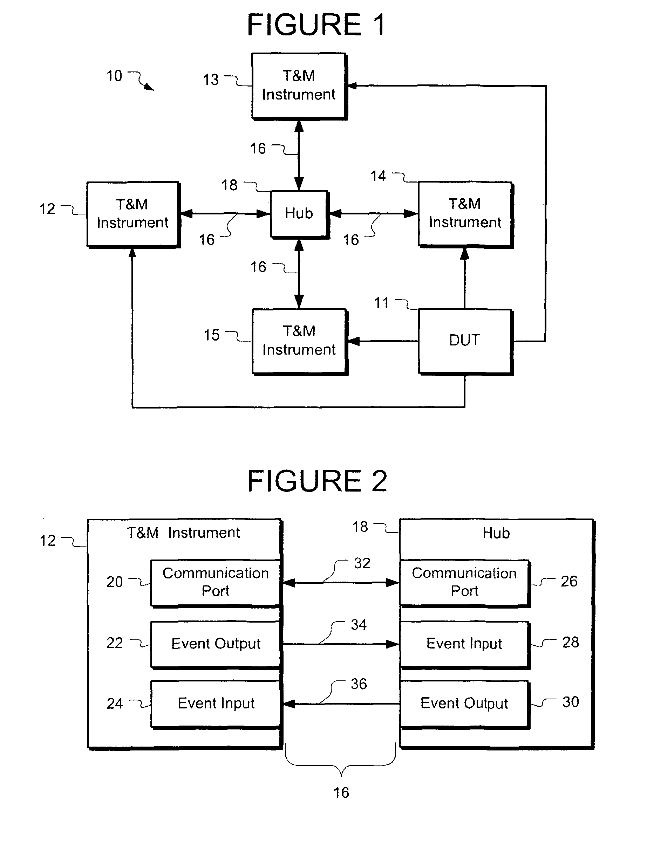

FIGURE 1 is a block diagram of a measurement system according to an embodiment. In this embodiment, a measurement system 10 includes multiple test and measurement instruments 12-15 coupled to a hub 18. The test and measurement instruments 12-15 are each coupled to the hub 18 through a communication link 16. In particular, each of the test and measurement instruments 12-15 can be configured to trigger an acquisition in response to an event received from the hub 18 through the communication line 16. The measurement system 10 can be coupled to a device under test 11 (DUT). Each of the test and measurement systems 12-15 can be coupled to the DUT 11.

The test and measurement instruments 12-15 can include any variety of instruments. For example, a test and measurement instrument can include an oscilloscope, a logic analyzer, a network analyzer, a spectrum analyzer, or the like. Any instrument that can acquire data in response to an event can be used as a test and measurement instrument.

An event can be any variety of conditions. For example, an event can be a rising edge, a level, a glitch, a pulse width, or the like. In another example, an event can include a packet type, a data sequence, or the like. An event can include a combination of such events. Any occurrence measurable by a test and measurement instrument can be an event.

Events can, but need not be consistent between test and measurement instruments.
For example, a logic analyzer can detect a particular data sequence on the DUT 11 as an event. An oscilloscope can detect a pulse width. That is, some of the test and measurement instruments 12-15 can be monitoring the DUT 11 for different types of events.

In particular, in an embodiment, different types of test and measurement instruments 12-15 can be coupled together and can trigger based on the same event. For example, assume that test and measurement instrument 12 is a logic analyzer monitoring the DUT 11 for a particular data pattern and test and measurement instrument 13 is an oscilloscope monitoring the DUT 11 for an edge with a particular rise-time. The oscilloscope 13 can detect the edge and transmit the detection event to the hub 18. The hub 18 can transmit the event to each of the test and measurement instruments 12-15, causing the test and measurement instruments 12-15 to acquire data. Alternatively, the acquisition can similarly be triggered by a particular data pattern detected on the logic analyzer 12.

In another embodiment, each of the test and measurement instruments 12-15 can be the same or substantially similar. For example each test and measurement instruments 12-15 can be an oscilloscope. A particular event on one instrument can be used to trigger an acquisition on all of the test and measurement instruments 12-15. Regardless of the type of test and measurement instruments used, in an embodiment, a measurement system 10 can be created having the capabilities of the multiple test and measurement instruments 12-15 and synchronizes substantially similar to a single integrated test and measurement instrument. Thus, a measurement system 10 can be created where trigger conditions beyond the capabilities of a single test and measurement instrument can be used.

Although four test and measurement instruments have been illustrated, any number of test and measurement instruments can be part of the measurement system 10. In particular, any number of test and measurements greater than one can be used.

In addition, although the hub 18 has been illustrated as being separate from the test and measurement instruments 12-15, in an embodiment the hub 18 can be part of one of the test and measurement instruments 12-15. For example, the hub 18 can be integrated with the test and measurement instrument 12. The connections to the other test and measurement instruments 12-15 can be achieved through external connections to the test and measurement instrument 12. Regardless, the measurement system 10 can be created where events can be routed through the hub 18.

FIGURE 2 is a block diagram illustrating a connection of a test and measurement instrument and a hub in the measurement system of FIGURE 1. In this embodiment, the communications link 16 includes a communication line 32 and event transmission lines 34 and 36. The communication line 32 and event transmission lines 34 and 36 can be formed by any variety of connections. For example, the event transmission lines 34 and 36 can be coaxial cables, twisted pair cables, or the like. The communication line 32 can similarly include any variety of connections.

The test and measurement instrument 12 can include a communication port 20 coupled to a communication port 26 on the hub 18. An event output 22 of test and measurement instrument 12 can be coupled to an event input 28 of the hub 18 through the event transmission line 34. An event input 24 of the test and measurement instrument 12 can be coupled to an event output 30 of the hub 18 through the event transmission line 36.

In an embodiment, the event output 22 can be configured to output an event to the hub 18. The hub 18 can be configured to receive the event through the event input 28. The hub 18 can be configured to process the event then transmit the event through the event output 30 to be received by the event input 24.

Although the communication of an event of the test and measurement instrument 12 to and from the hub 18 has been described as separate, the transmission of such events can be over a single communication link. For example, in one embodiment, each of the event input and event output pairs can be coupled by a coaxial cable. In another embodiment, a separate coaxial cable can couple the event inputs to the corresponding event outputs. Regardless, an event can be sent to the hub 18 and an event can be received from the hub 18.

In an embodiment, the event transmission lines 34 and 36 can be formed such that communications over the event transmission lines 34 and 36 can be substantially similar. For example, a time delay through the event transmission line 34 can be substantially similar to a time delay through the event transmission line 36. Accordingly, as will be described below, a propagation time to the hub 18 can be calculated.

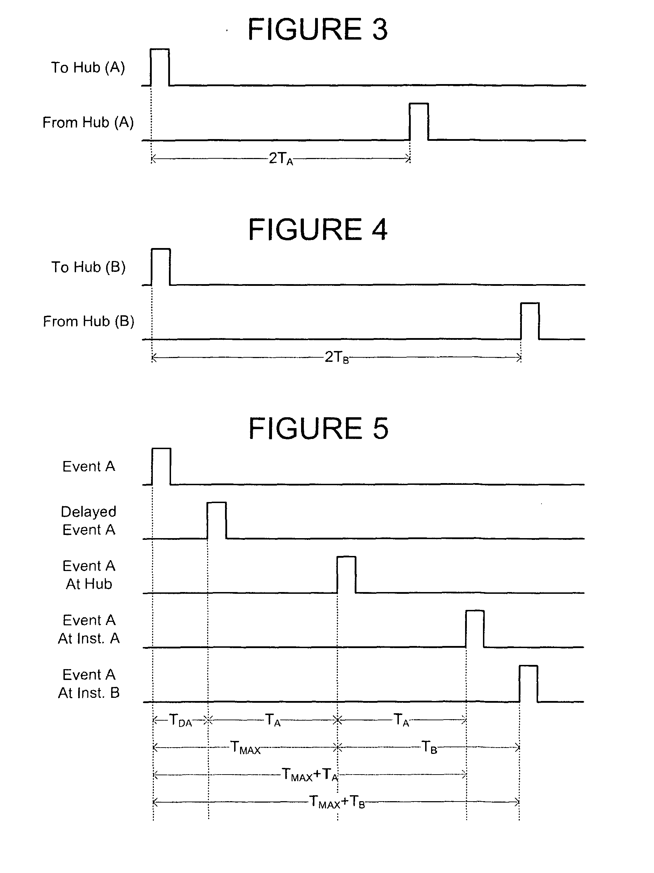

FIGURES 3 and 4 are timing diagrams illustrating measurements of round-trip times for two test and measurement instruments according to an embodiment. FIGURE 3 illustrates a timing diagram for test and measurement instrument A while FIGURE 4 illustrates a timing diagram for instrument B.

In particular, the timing diagrams represent the timing of a round-trip transmission of an event to and from the hub 18. For example, referring to FIGURE 3, an event can be transmitted from test and measurement instrument A through the event output 22 to the hub 18. After a time 2*T_{A}, the event can be received from the hub 18 through the event input 24. In particular, the round-trip time to and from the hub 18 can be measured. As will be described in further detail below, the hub 18 can be configured such that during this measurement, the hub 18 returns the event transmitted by the particular test and measurement instrument.

In this embodiment, the round-trip time is represented as time 2*T_{A}. Thus, the propagation time to the hub 18 can be approximated as T_{A}. Similarly, a round-trip time 2*T_{B} for test and measurement instrument B can be measured. In particular, as will be described in further detail below, each test and measurement instrument can be configured to measure the round-trip time between itself and the hub 18. Accordingly, each test and measurement instrument can measure a time for an event to travel from the test and measurement instrument to the hub 18.

FIGURE 5 is a timing diagram illustrating an event from a first test and measurement instrument propagating to multiple test and measurement instruments according to an embodiment. It should be noted that in an embodiment, the round-trip times can be different between different test and measurement instruments. However, with such a measurement, the triggering of the test and measurements instruments can be substantially synchronized.

In particular, test and measurement instrument A can generate an event. The event can be delayed by a time T_{DA}. In particular, the time T_{DA} can be a difference between the time T_{A} and a maximum of times T_{A} and T_{B}. T_{MAX} represents this maximum time. In this embodiment, time T_{B} is the maximum time T_{MAX}. Each test and measurement instrument can be configured to delay any locally generated events by such a delay time specific to the test and measurement instrument.

The delayed event is then output from the test and measurement instrument A to the hub 18. The event takes time T_{A} to reach the hub 18. Since the event was delayed by time T_{DA} and took time T_{A} to reach the hub, the total time is T_{DA} + T_{A} or T_{MAX}. Similarly, as each test and measurement instrument can delay locally generated events by a time corresponding to the particular instrument, contemporaneous events from different instruments can arrive at the hub 18 at substantially the same time. That is, regardless of the test and measurement instrument that generated the event, the event can reach the hub 18 a time T_{MAX} after the event occurred. In other words, the time alignment of events on a DUT 11 can be substantially preserved in the events arriving at the hub 18.

The hub 18 can be configured to propagate the event to each of the test and measurement instruments. However, as the transmission delay time can be different, the event can reach the various test and measurement instruments at different times. For example, after time T_{A}, the event can reach test and measurement A as illustrated. Similarly, after time T_{B}, the event can reach test and measurement B as illustrated.

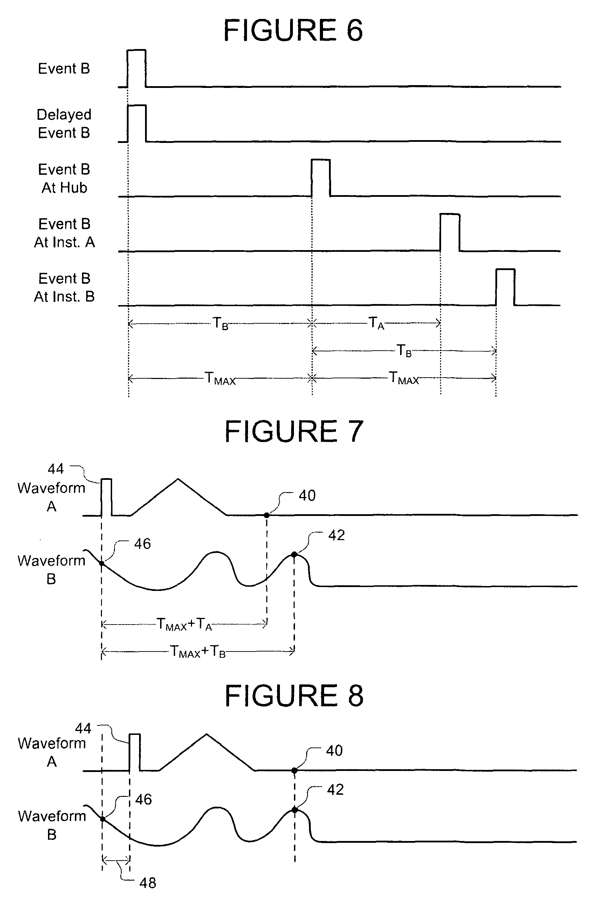

FIGURE 6 is a timing diagram illustrating an event from a second test and measurement instrument propagating to multiple test and measurement instruments according to an embodiment. To illustrate the synchronization substantially independent of the source of an event, an event generated by test and measurement B is illustrated similar to the event of test and measurement instrument A in FIGURE 5.

In FIGURE 6, an event is generated on test and measurement instrument B. As instrument B has the maximum time to the hub 18, its time T_{B} is the time T_{MAX}. Thus the delayed event at test and measurement instrument B is substantially not delayed relative to the generated event. However, since the propagation time to the hub is T_{B}, the event still arrives at the hub 18 after time T_{MAX} since in this example, T_{B} is the time T_{MAX}. Once at the hub 18, the event can be propagated to the test and measurement instruments. The events arriving at test and measurement instruments A and B are substantially similar as those illustrated in FIGURE 5 since the event arrived at the hub 18 at substantially the same time.

FIGURE 7 is a diagram illustrating a time relationship of waveforms on a device under test according to an embodiment. Waveform A represents a waveform on a DUT 11 probed by test and measurement instrument A. Similarly, waveform B represents a waveform on a DUT 11 probed by test and measurement instrument B. The waveforms are illustrated as they existed in time on the DUT 11.

In this embodiment, an edge 44 of waveform A is used as the event. That is, in response to the edge 44, test and measurement instrument A generates an event similar to event A illustrated in FIGURE 5. As described above, the event is returned to test and measurement instrument A after a time T_{MAX} + T_{A}. In response to the event, the test and measurement instrument A can trigger an acquisition. Trigger point 40 illustrates the point in time relative to the occurrence of waveform A on the DUT 11 where the event was received and a trigger occurred.

Similarly, the same event can be received at test and measurement instrument B where the acquisition of waveform B can be triggered. However, as described above, the time the event takes from the occurrence of the event to the time the event reaches the test and measurement instrument is different for each test and measurement instrument. In this example, the time is T_{MAX} + T_{B}. Thus, test and measurement instrument B triggers an acquisition of waveform B after a time T_{MAX} + T_{B}. Trigger point 42 of waveform B represents this trigger point. For reference, point 46 on waveform B represents the location on waveform B that occurred contemporaneous with the edge 44.

FIGURE 8 is a diagram illustrating a time relationship of the waveforms of FIGURE 7 with the respective trigger points aligned. As illustrated, the trigger points 40 and 42 of the waveforms A and B were used to align the waveforms A and B in time. However, as described above, the occurrence of the trigger points in time were not the same. As a result, a time error 48 is introduced between contemporaneous points of the waveforms A and B, such as the edge 44 of waveform A and the point 46 of waveform B.

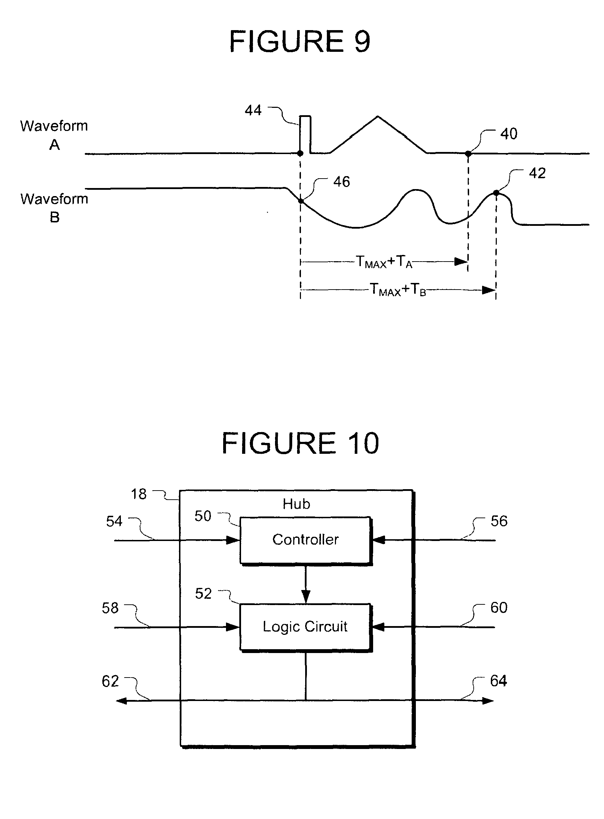

FIGURE 9 is a diagram illustrating a time relationship of the waveforms offset in time according to an embodiment. In this embodiment, each of the waveforms A and B has been offset in time from their respective trigger points by the event propagation time particular to the corresponding test and measurement instrument. That is, waveform A has been offset by time T_{MAX} + T_{A} and waveform B has been offset by time T_{MAX} + T_{B}. Accordingly, the presentation of the waveforms A and B are now aligned in time substantially equivalent to the time alignment on the DUT 11 as illustrated in FIGURE 7.

Thus, once a calibration has been performed where times such as the transmission time T_{A}, time T_{MAX}, the difference time T_{DA} have been determined, a given test and measurement instrument can, but need not know the identity of the test and measurement instrument that generated the event. In other words, each test and measurement instrument can be configured to delay its own events such that the time from the occurrence of an event to the time the event reaches the hub 18 is substantially similar for any test and measurement instrument.

As each test and measurement instrument characterized its connection to the hub 18, each test and measurement instrument can adjust its acquisition, triggering, presentation of data, or the like to account for the particular return time from the hub. That is, as the events are synchronized at the hub 18, any remaining time offset introduced can be substantially only dependent on the return path to the particular test and measurement instrument. Accordingly, the test and measurement instrument can account for such difference in time and synchronize the acquired data without information regarding which test and measurement instrument generated the event.

Although a time T_{MAX} has been described as being the maximum of the propagation times to the hub among the test and measurement instruments, the time can, but need not be the maximum. In an embodiment, the time can be greater than the maximum time. The difference times such as time T_{DA} can still be calculated with respect to the greater time. However, in this embodiment T_{DB}, or the difference time for test and measurement instrument B, which had the maximum time above, can be greater than substantially zero.

FIGURE 10 is a block diagram of a hub according to an embodiment. In this embodiment, the hub 18 includes a controller 50 and a logic circuit 52. The controller 50 can be coupled to the test and measurement instruments through communication lines 54 and 56. Although individual communication lines have been described, a single communication system among the test and measurement instruments can be used.

The logic circuit 52 is configured to combine events received from the test and measurement instruments. For example, event transmission lines 58 and 60 can provide events to the logic circuit 52. After any processing, combination, or the like, the event can be propagated to the various test and measurement instruments through event transmission lines 62 and 64.

In an embodiment, the hub 18 can be configured as an aggregator of events. That is, the logic circuit of the hub 18 can be can be configured to propagate any event that the hub 18 receives. For example, the logic circuit 52 can include a logical OR of any received event. Thus, any event will generate an output event propagated to the test and measurement instruments.

However, in another embodiment, the hub 18 can be configured to combine events together. For example, the logic circuit 52 can include a logical AND of any received event. Thus, the multiple events must occur substantially together in order for an event to be propagated to the test and measurement instruments.

Although a logical OR function and a logical AND function have been described above, any combination of events can be used. For example, a multi-gate logic system can be used to combine the events. In another example, a state machine can be used with the various events from the test and measurement instruments as inputs.

In particular, it should be noted that a test and measurement instrument can, but need not have any information regarding the combination of events in the logic circuit 52. A test and measurement instrument can be configured to trigger on any event received from the hub 18. As described above, the test and measurement instrument need not know the source of the event.

In an embodiment, the event received from the hub 18 can, but need not be the sole condition for triggering an acquisition. For example, the event received from a hub 18 can be combined just as any other event in the triggering system of the particular test and measurement instrument. Thus, an even more complex trigger can be generated than that resulting in the event received from the hub 18.

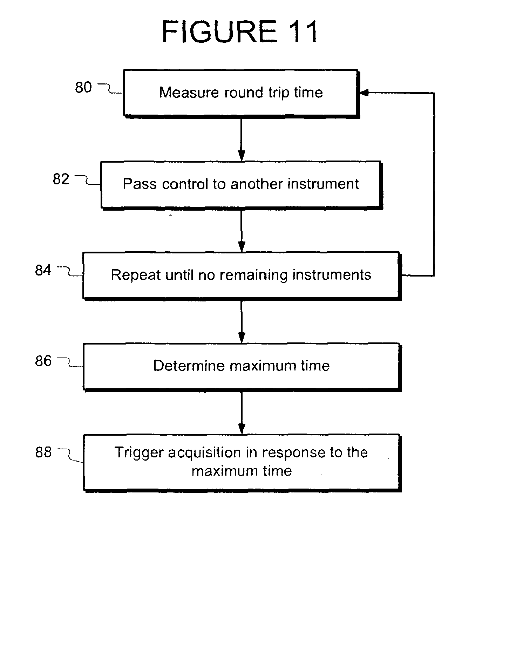

FIGURE 11 is a flowchart illustrating an example of a calibration of multiple test and measurement instruments. As described above, the maximum of the propagation times to the hub 18 or greater can be used to substantially synchronize events reaching the hub 18. Thus, the individual test and measurement instruments need not know the source of any received event.

In an embodiment, to remove a need to know the source, a calibration can be performed. For example, in 80 a round-trip time of an event to and from the hub 18 can be measured for a first test and measurement instrument. In particular, the test and measurement instrument can be configured to cause the hub 18 to enter a configuration mode where the hub 18 returns an event received from the test and measurement instrument back to the test and measurement instrument.

For example, the test and measurement instrument can control the hub 18 to disregard any events received from other test and measurement instruments. As described above, if the logic circuit 52 of the hub 18 includes a logical AND operation, the other inputs to the logical AND operation can be set to a high level. Similarly, with a logical OR operation, the other inputs can be set to a logical low level. In another example, a state machine in the logic circuit 52 can be set to a state that disregards events from other test and measurement instruments. Regardless, the hub can be controlled such that only events from one test and measurement instruments can be propagated.

Accordingly, the test and measurement instrument can generate an event and measure a time between that event and an event received from the hub 18. As described above, events from the hub 18 can come from a variety of sources; however, in this calibration mode, the only event that will be propagated is an event from the test and measurement instrument currently performing a calibration. The round-trip time can be measured and used as described above.

Once the measurement is performed, the test and measurement instrument can pass control of the hub to another test and measurement instrument in 82. In 84 the measurement in 80 and the passing of control in 82 can be repeatedly performed until there are no remaining test and measurement instruments coupled to the hub. Accordingly, each test and measurement instrument will have measured the round-trip time and can calculate the propagation time to the hub 18.

In an embodiment, the test and measurement instrument that initiated the calibration can be configured to determine a maximum of the propagation times to the hub in 86. Such a maximum can be determined in a variety of ways. For example, the test and measurement instrument can receive the round-trip times for each of the test and measurement instruments. The maximum can be calculated and divided in half to determine the maximum propagation time to the hub. Similarly, the test and measurement instrument can receive the propagation times individually calculated by the corresponding test and measurement instruments, then calculate a maximum. Moreover, the test and measurement instrument can select a time greater that the actual maximum as the maximum time. Thus, as described above, a time that is greater than or equal to the largest propagation time can be calculated and used in the triggering of acquisitions.

This maximum time can be communicated to each of the test and measurement instruments. For example, the test and measurement instruments can communicate with each other through the hub, another communication interface, such as an Ethernet interface, or the like. Accordingly, each test and measurement instrument can configure itself based on its own propagation time such that events arrive at the hub substantially simultaneously. As a result, in response to this maximum time, in 88 the test and measurement instruments can trigger an acquisition and the presentation of data can be substantially aligned in time as described above.

Although a test and measurement instrument has been described as initiating and/or controlling the calculation of such a maximum time, the maximum time can be calculated in other ways. For example, the hub 18 can initiate a calibration, and communicate to each test and measurement instrument in turn instructions to generate an event. The hub 18 can be configured to collect the various propagation times or round-trip times and communicate the calculated maximum to the test and measurement instruments. Accordingly, the test and measurement instruments can, but need not be aware of any other instruments.

Moreover, in an embodiment, such a calibration can be performed in response to various conditions. For example, as described above, the calibration can be initiated by one of the test and measurement instruments. A user can press a calibration button; select a calibration menu item, or the like. In another example, the calibration can be performed in response to the detection of a new test and measurement instrument. That is, a new test and measurement instrument can be coupled to the hub 18. The new test and measurement instrument can inform the hub 18, the other test and measurement instruments, or the like of its presence. In response a new calibration can be performed such that the propagation times for each of the test and measurement instruments including the new test and measurement instrument can be measured, combined into a maximum or the like, as described above.

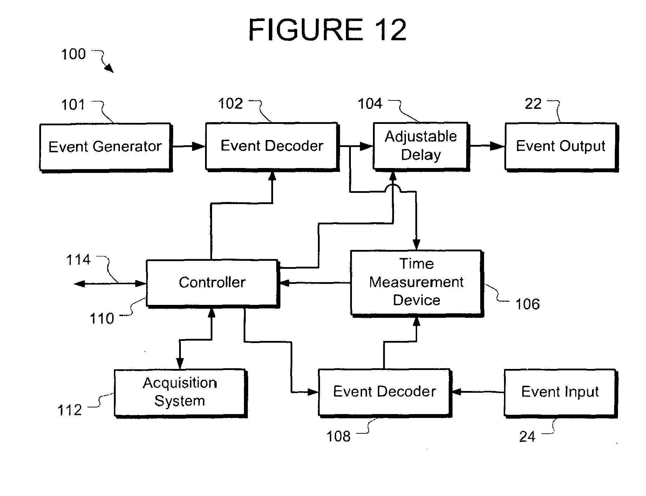

FIGURE 12 is a block diagram of a test and measurement instrument according to an embodiment. In an embodiment, the test and measurement instrument 100 includes an event generator 101. The event generator 101 represents the systems that can generate the various events described above. For example, the event generator 101 can include the circuitry, pattern analysis, or the like to detect a transition, match a data pattern, or the like. The test and measurement instrument 100 can have any number of such event generators 101.

The test and measurement instrument 100 includes a first event decoder 102. The first event decoder 102 is configured to select an event from the first event decoder 102, combine such events, or the like. The event decoder 102 can be configured to generate an event, propagate an event, or the like.

An event from the event decoder 102 can be delayed by the delay 104. The delay 104 can be adjusted by the controller 110 such that a time through the delay 104 can be the difference time such as time T_{DA} described above. Thus, the event from the event decoder 102 can be delayed as described above before being output through the event output 22 to a hub 18.

The test and measurement instrument can also include an event input 24 coupled to a second event decoder 108. The second event decoder 108 can be substantially similar to the first event decoder 108. That is, the second event decoder 108 can also receive events from one or more event generators 101. However, the second event decoder 108 can use the event from the event input 24 in a manner substantially similar to internal events. That is, using the timing capabilities of the trigger circuitry represented by time measurement device 106, a time between the event from the first event decoder 102 and the event received thought he event input 24 can be measured.

Although an event from the event input 24 has been described as being input to the time measurement device 106 through the second event decoder 108, the event input 24 can be directly coupled to the time measurement device 106, coupled to a dedicated time measurement device 106 along with the first event decoder 102, or the like. That is, the round-trip time, propagation time, or the like can be measured with the time measurement device 106 of the trigger circuitry as illustrated, a dedicated timer, or the like.

The controller 110 can be configured to trigger an acquisition of the acquisition system 112 in response to an event received through the input 24. That is, the event received through the input 24 can be used by the controller 110 to trigger an acquisition similar to other events generated by the event decoder 108. However, as described above, the time alignment of the data to data acquired by other test and measurement instruments can be skewed. Accordingly, the controller 110 can be configured to offset the acquired data in response to a time associated with the test and measurement instrument and at least one other test and measurement instrument. For example, such a time can be the time T_{MAX} + T_{A} as described above

The controller 110 can also be coupled to a communication interface 114. As a result, the controller can be configured to receive the propagation times, maximum time, or the like associated with the other test and measurement instruments. The controller 110 can then be configured to calculate the delay time for the delay 104, an offset time for the time base, or the like as described above.
Although particular embodiments have been described, it will be appreciated that the principles of the invention are not limited to those embodiments. Variations and modifications may be made without departing from the principles of the invention as set forth in the following claims.

## Claims

1. A measurement system comprising:
a plurality of test and measurement instruments; and
a hub coupled to each of the test and measurement instruments;
wherein each of the test and measurement instruments is configured to trigger an acquisition in response to a hub event received from the hub;
each of the test and measurement instruments is configured to generate an instrument event;
the hub includes a logic circuit to combine the instrument events to generate the hub event;
each test and measurement instrument includes an input and an output coupled to the hub; and
each test and measurement instrument includes a time delay of a communication from the output to the hub is substantially similar to a time delay of a communication from the hub to the input; and
the test and measurement instrument is configured to cause the hub to enter a configuration mode where the hub returns an event received from the test and measurement instrument to the test and measurement instrument; and
the test and measurement instrument is configured to measure a time the event takes to be returned from the hub.

2. The measurement system of claim 1, wherein for each test and measurement instrument:
the test and measurement instrument is configured to pass control of the hub to another test and measurement instrument after the test and measurement instrument has measured the time the event takes to be returned from the hub.

3. The measurement system of claim 2, wherein:
at least one of the test and measurement instruments is configured to determine a maximum time of the times the events take to be returned from the hub; and
each of the test and measurement instruments is configured to trigger the acquisition in response to the maximum time.

4. A method, comprising:
measuring a round-trip time from a hub to a test and measurement instrument; receiving an event from the hub at the test and measurement instrument;
acquiring data in response to the event; and
adjusting a time base of a presentation of the data in response to the round-trip time.

5. The method of claim 4, further comprising:
outputting a first event from the test and measurement instrument;
receiving a second event from the hub;
measuring a time between the outputting of the first event and the receiving of the second event; and
determining the time base in response to the measured time.

6. The method of claim 4, further comprising:
entering a configuration mode on the hub in response to the test and measurement instrument.

7. The method of claim 4, further comprising:
generating an event;
delaying the event by a time; and
outputting the delayed event from the test and measurement instrument.

8. The method of claim 4, further comprising communicating to a second test and measurement device to perform a calibration with the hub.

9. The method of claim 4, further comprising measuring a round-trip time between a second test and measurement instrument and the hub.

10. The method of claim 4, further comprising determining the adjustment of the time base in response to round-trip times from each test and measurement instrument coupled to the hub.
